# DEMANDE DE BREVET EUROPEEN

(11) **EP 0 724 930 A1**
(43) Date de publication de la demande: **07.08.1996**
(21) Numéro de dépôt: 96400207.5
(22) Date de dépôt: 29.01.1996
(51) Int. Cl.: B23K 35/00, C23C 14/28, H01L 21/60

(54) **Dispositif comprenant des plots de soudage formés sur un substrat et méthode de fabrication de tels plots de soudage**

(30) Priorité: 01.02.1995 FR 9501164
(71) Demandeur: ALCATEL N.V., NL-2288 BH Rijswijk (NL)
(72) Inventeur: Belouet, Christian, F-92330 Sceaux (FR); Queriaud, Roland, F-91220 Bretigny s/Orge (FR)
(74) Mandataire: Pothet, Jean Rémy Emile Ludovic

(57) **Abrégé**

Des plots de soudage (2) sont formés sur un substrat (3) et comprennent, en partant du substrat (3), une sous-couche d'accrochage (4), une couche intermédiaire de protection (5) et une couche de soudage (6).
La couche intermédiaire (5) est en un alliage de deux métaux au moins, un premier métal (W) offrant la propriété d'une couche de barrière et un deuxième métal (Ti) offrant la propriété de mouillage, vis-à-vis de la couche de soudage. La proportion du premier métal (W) dans l'alliage diminue graduellement en direction de la couche de soudage, depuis une valeur assez élevée pour que la propriété de couche de barrière soit obtenue, jusqu'à une valeur qui soit assez faible pour que la part du deuxième métal (Ti) soit elle-même assez élevée pour que la propriété de mouillabilité soit obtenue

## Description

La présente invention concerne un dispositif comprenant des plots de soudage formés sur un substrat, ces plots de soudage comprenant, à partir du substrat, une sous-couche d'accrochage, une couche intermédiaire de protection et une couche de soudage. Elle propose également une méthode de fabrication de tels plots de soudage. Ceux-ci serviront, notamment, au montage de composants électroniques ou optoélectroniques sur un substrat commun (technologie connue dite "flip-chip", par exemple).

On trouvera une description d'une forme d'un tel dispositif dans l'article "Advanced metallization schemes for bonding of InP-based laser devices to CVD-diamond heatsinks", de A. Katz et al, dans la publication "Materials, Chemistry and Physics", n°37, 1994, pages 303-328, qui traite d'un substrat en diamant comportant des plots de soudage et qui, à l'endroit de chaque plot, est recouvert d'abord d'une couche d'accrochage en titane, puis d'une couche de protection en platine et enfin d'une couche de soudage en alliage étain-or. Il y est exposé que la solubilité de l'étain dans le platine et le titane pendant le soudage peut conduire à une rupture du plot de soudure.

Les auteurs examinent alors de nombreuses solutions à ce problème dont certaines consistent en ce que la couche de protection soit une structure multi-couches comprenant au moins une couche d'un métal constituant une barrière arrêtant la migration de l'étain pendant le soudage, tel que le tungstène, recouverte d'une ou plusieurs autres couches d'un ou plusieurs autres métaux, dont certains au moins, le titane ou le nickel notamment, offrent la mouillabilité nécessaire vis à vis de l'alliage étain-or.

Une telle solution, bien qu'efficace, est coûteuse, en raison de ce qu'elle demande le dépôt de plusieurs couches et en raison de la technique d'évaporation employée, relativement lente et délicate à mettre en oeuvre.

L'article "Bonding of InP laser diodes by Au-Sn solder and tungsten-based barrier-metallization schemes" de C.H. Lee et al traite d'un sujet similaire et propose le même type de solution souffrant des mêmes inconvénients. Le brevet US 5,234,153 appelle le même commentaire.

Il existe donc un problème qui consiste à apporter, dans un plot de soudage, une couche ayant une propriété de couche barrière et une couche ayant la propriété de mouillabilité vis-à-vis de la couche de soudage, comme mentionné ci-dessus et cela sans exiger le dépôt de plusieurs couches et l'emploi de techniques lentes et délicates à mettre en oeuvre.

La présente invention apporte une solution à ce problème.

Selon l'invention, les plots de soudage comprennant une couche intermédiaire de protection composée d'un alliage de deux métaux au moins, un premier métal offrant la propriété d'une couche de barrière et un deuxième métal offrant la propriété de mouillage, vis-à-vis de la couche de soudage, la proportion du premier métal dans l'alliage diminue graduellement en direction de la couche de soudage, depuis une valeur assez élevée pour que la propriété de couche de barrière soit obtenue, jusqu'à une valeur qui soit assez faible pour que la part du deuxième métal soit elle-même assez élevée pour que la propriété de mouillabilité soit obtenue.

Dans un exemple pratique, la proportion du premier métal, en poids, décroît de 100 % à 90 %, tandis que la proportion du deuxième métal, en poids également, augmente de 0 à 10 %.

De préférence, ladite couche de soudage est faite d'un alliage étain-or. De préférence encore, ledit alliage a une composition homogène dans l'épaisseur de cette couche. De préférence encore, ledit premier métal est le tungstène. Ledit deuxième métal est le titane, ou le nickel ou un mélange titane-nickel.

De préférence, ladite couche intermédiaire de protection de l'invention est obtenue par la technique connue de dépôt par ablation laser PLD (Pulse Laser-assisted Deposition, en anglais). Selon cette technique, le faisceau laser est focalisé cycliquement sur différentes cibles et, sur chaque cible, un nombre programmable de tirs sont effectués, déterminant le dépôt d'une quantité correspondante du métal de cette cible. Le nombre de tirs consécutifs du laser sur chaque cible est modifié progressivement de façon que lesdites proportions soient obtenues.

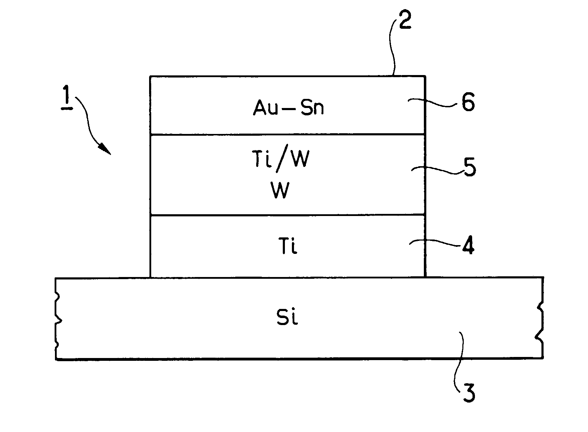

Les différents objets et caractéristiques de l'invention seront maintenant exposés de façon plus détaillée dans la description qui va suivre d'un exemple de mise en oeuvre de l'invention, fourni à titre non limitatif, faite en se référant à la figure annexée qui représente une vue en coupe axiale d'une partie d'un dispositif comportant une plot conforme à l'invention.

La figure représente une partie d'un dispositif 1 conforme à l'invention, vue en coupe par l'axe d'un plot de soudage 2 formé sur un substrat 3. Ce plot de soudage comprend, à partir du substrat 3, une sous-couche d'accrochage 4, une couche intermédiaire de protection 5 et une couche de soudage 6.

Selon l'invention, la composition de la couche intermédiaire 5 diminue graduellement, en direction de la couche de soudage 6, depuis une une valeur assez élevée pour que la propriété de couche de barrière soit obtenue, jusqu'à une valeur qui soit assez faible pour que la part du deuxième métal soit elle-même assez élevée pour que la propriété de mouillabilité soit obtenue.

Dans une forme de réalisation, le substrat est en silicium (Si), la sous-couche en titane (Ti), la couche intermédiaire comprend du tungstène (W) et du titane (Ti), tandis que la couche de soudage comprend de l'étain (Sn) et de l'or (Au).

Typiquement, la couche de soudage comprend, en poids, 20 % d'étain et 80 % d'or.

De préférence, la couche intermédiaire comprend initialement, à partir de la sous-couche 4, du W à 100 %, pour évoluer graduellement jusqu'à la couche de soudage au voisinage de laquelle la composition comprend 90 % de W et 10 % de Ti.

Selon une alternative, dans la couche intermédiaire 5, le Ti peut être complacé par le nickel (Ni) ou par une composition Ti, Ni, la proportion de W restant inchangée.

L'invention prévoit de réaliser la couche intermédiaire au moins, mais de préférence toutes les couches du plot 2 par la technique du dépôt par ablation laser.

Des cibles en W et Ti sont disposées dans une enceinte à vide contenant le substrat 3 et des tirs d'un laser UV pulsé vaporisent chacun une certaine quantité de W ou de Ti. La séquence des tirs sur les deux cibles permet initialement de vaporiser du W seulement, engendrant un dépôt de W à 100 % sur le substrat, puis un nombre croissant de tirs sur la cible en Ti, font que la composition de la couche intermédiaire déposée évolue graduellement et atteigne 90 % de W et 10 % de Ti. Une cible en Ni peut remplacer la cible en Ti, ou être disposée en sus, pour l'obtention de compositions où le Ni remplace, en totalité ou en partie le Ti.

De la même façon, la sous-couche de Ti sera de préférence déposée par l'emploi de la même méthode et du même équipement d'ablation laser, en orientant les tirs, dans un premier temps, uniquement vers la cible en Ti.

De même encore, la couche Sn-Au sera déposée par la méthode du dépôt par ablation laser, des cibles en Sn et Au étant disposées dans une enceinte à vide et la séquence des tirs vers ces deux cibles permettant d'obtenir une couche homogène de la composition voulue, indiquée plus haut.

L'emploi généralisé de la technique du dépôt par ablation laser, outre l'avantage du contrôle précis et donc aisément reproductible des compositions des couches déposées, permet de donner à ces couches des épaisseurs supérieures à celles des autres techniques d'évaporation ou de pulvérisation.

La localisation des plots de soudage sur le substrat sera obtenue, couche par couche de préférence, par une technique classique de photolithographie, suivie d'un "lift-off".

Il est bien évident que les descriptions qui précèdent l'on été données qu'à titre d'exemple non limitatif. En particulier, il est clair que l'invention s'applique quelle que soit la matière du substrat, que le substrat peut en lui-même constituer ladite sous-couche, qu'une ou plusieurs couches intercalaires peuvent être présente, que la composition de la couche de soudage peut être autre, l'étain pouvant être totalement ou partiellement remplacé par un autre métal à bas point de fusion et l'or par un autre métal de conductibilité électrique et thermique élevée.

## Revendications

1. Dispositif comprenant des plots de soudage formés sur un substrat, ces plots de soudage comprenant, à partir du substrat, une sous-couche d'accrochage, une couche intermédiaire de protection et une couche de soudage, ladite couche intermédiaire de protection étant composée d'un alliage de deux métaux au moins, un premier métal offrant la propriété d'une couche de barrière et un deuxième métal offrant la propriété de mouillage, vis-à-vis de la couche de soudage, caractérisé en ce que la proportion du premier métal (W) dans l'alliage diminue graduellement en direction de la couche de soudage, depuis une valeur assez élevée pour que la propriété de couche de barrière soit obtenue, jusqu'à une valeur qui soit assez faible pour que la part du deuxième métal (Ti) soit elle-même assez élevée pour que la propriété de mouillabilité soit obtenue.

2. Dispositif conforme à la revendication 1, caractérisé en ce que la proportion du premier métal (W), en poids, décroît de 100 % à 90 %, tandis que la proportion du deuxième métal (Ti), en poids également, augmente de 0 à 10 %.

3. Dispositif conforme à la revendication 1 ou 2, caractérisé en ce que ladite couche de soudage 6 étant faite d'un alliage étain-or, de composition homogène dans l'épaisseur de cette couche, ledit premier métal est le tungstène.

4. Dispositif conforme à la revendication 1, 2 ou 3, caractérisé en ce que ledit deuxième métal est l'un du groupe comprenant le titane, le nickel ou un mélange titane-nickel.

5. Méthode de fabrication d'un dispositif conforme à la revendication 1, 2, 3 ou 4, caractérisé en ce que ladite couche intermédiaire de protection (5) est obtenue par la technique de dépôt par ablation laser, la durée moyenne de bombardement de cibles dans les premier et deuxième métaux étant modifiée progressivement de façon que lesdites proportions soient obtenues.
